# EUROPEAN PATENT SPECIFICATION

(11) **EP 2 224 550 B1**
(45) Date of publication and mention of the grant of the patent: **14.03.2012**
(21) Application number: 09164683.6
(22) Date of filing: 06.07.2009
(51) Int. Cl.: H01R 13/635, H01R 35/04

(54) **A pen featuring as a usb memory device**
Stift mit USB-Speichervorrichtung
Stylo fonctionnant en tant que dispositif de mémoire USB

(30) Priority: 27.02.2009 TW 98106325
(43) Date of publication of application: 01.09.2010
(73) Proprietor: Walton Advanced Engineering Inc., Kaohsiung City 806 (TW)
(72) Inventor: YU, Hong-Chi, Kaohsiung City (TW)
(74) Representative: Intès, Didier Gérard André

(56) References cited:
- KR-A- 20080 061 071
- US-A1- 2004 103 228
- US-A1- 2007 015 407
- US-A1- 2007 127 219
- US-A1- 2007 184 685
- US-B1- 7 004 780

## Description

### FIELD OF THE INVENTION

The present invention relates to a pen featuring as a USB memory device, and more particularly to one having writing function with portability, holding comfort, easy accommodation and adaptability to a memory device with foldable plug and USB interface.

### BACKGROUND OF THE INVENTION

Owing to the rapid development of information technology, digital electronic products have been widely spread into various life areas of all walks of life. The growing adoption of digital electronic products makes people no longer content with the available functionality as far as the expectation on digital electronic products is concerned, and the frequent use urges that people are eager to find relevant products with integrated purpose and highly efficient portability.

In general, pen is one of the daily tools normally used by people and owns remarkable portability. Regular pens we know normally serve for writing purpose only. As a result, if a pen with a digital data storage device could be available, it allows user not only to write but also to provide additional digital data storing capability, making that the pen with integrated functions highly enhances its convenience.

The applicant submitted Taiwan Patent Number M24864 previously, which intends to add a memory device in collaboration with a USB (Universal-Serial-Bus) connector for enhancing user's carry-on and operational convenience. Whereas, in the course of the paramount development of semiconductor process, the brilliant development of miniaturization package technology, such as COB (Chip-On-Board) package or MCP (Multi-Chip-Package) process, brings into play the NVM (Non-Volatile Memory) with significant size reduction and increases its density to extensively integrate it with and apply it to other products.

Therefore, a pen equipped with a memory device can be more practical in actual application. The document US 2007 184685 discloses a pen with a USB flash drive.

### SUMMARY OF THE INVENTION

In accordance with a first aspect of the present invention, a pen featuring as a USB memory device is provided. Given the COB or MCP miniaturization package technology, the memory device has the advantage to have a compact size, and the technique of foldable connection plug is further adopted to house the connection plug and the memory in an accommodation room, so that the pen maintains its original writing function in conveniently carrying and holding with ease without increasing the outer diameter of the penholder.

In accordance with a second aspect of the present invention, a pen featuring as a USB memory device is provided. Given the COB or MCP miniaturization package technology, the memory device has the advantage to have a compact size, and the technique of foldable connection plug is further adopted to house the connection plug and the memory in an accommodation room, so that the memory device is easily accommodated and not easily lost.

In accordance with a third aspect of the present invention, a pen featuring as a USB memory device is provided. Given the COB or MCP miniaturization package technology, the memory device has the advantage to have compact size, and the technique of foldable connection plug is further adopted to house the connection plug and the memory in an accommodation room, so that the present invention maintains the writing function in conveniently carrying and holding with ease and serves as a memory device having a USB interface to enable the present invention to be multi-functional.

To achieve the foregoing aspects, the present invention employs the following technical means to ensure that the pen structure includes: a penholder, a foldable connection plug, and a main body; the penholder contains an upper penholder and a lower penholder, in which the upper penholder has an accommodation room therein, one end of the accommodation room communicates with an outer periphery of the upper penholder, at least a compression spring is disposed at the other end, the upper penholder has at least a spring member, and the lower penholder is provided to house the main body of the pen; the foldable connection plug is disposed in the accommodation room of the upper penholder and contains a support seat, at least a first connection part, at least a second connection part, and metal contacts being compatible with a USB transmission interface; the main body is disposed in the accommodation room of the upper penholder and contains at least an electronic component.

Alternatively, the aspects of the present invention can be achieved by the following means to ensure that the pen structure includes: a penholder, a foldable connection plug, and a main body; the penholder contains an upper penholder and a lower penholder, in which the upper penholder has an accommodation room therein, one end of the accommodation room communicates with an outer periphery of the upper penholder, and the lower penholder is provided to house the main body of the pen; the foldable connection plug is disposed in the accommodation room of the upper penholder and contains a support seat, at least a first connection part, at least a second connection part, and metal contacts being compatible with a USB transmission interface, the support seat has a recess, a movable seat is disposed on the recess, and the movable seat has a push part; the main body is housed in the accommodation room of the upper penholder and contains at least an electronic component.

In contrast to the conventional skill, the function and effect of the present invention lies in that the foldable characteristic of the foldable connection plug enables the plug to be housed in the accommodation room of the upper penholder so that the memory device is easily received without being lost easily and the original writing function of the pen in conveniently carrying and holding with ease can still be remained, making that the present invention is multi-functional.

### BRIEF DESCRIPTION OF THE DRAWINGS

Fig. 1 is an exploded view showing the parts in accordance with the first preferred embodiment of the present invention;

Fig. 2 is a plain view of the present invention;

Fig. 3 is an A-A sectional view in accordance with Fig. 2 of the present invention;

Fig. 4 is a B-B sectional view in accordance with Fig. 3 of the present invention;

Fig. 5 is a schematic view showing a memory module with a fastener in accordance with the present invention;

Fig. 6 is a schematic view showing the flow processes in accordance with the second preferred embodiment of the present invention;

Fig. 7 is an exploded view showing the parts in accordance with the second preferred embodiment of the present invention;

Fig. 8 is an exploded view showing the parts in accordance with the third preferred embodiment of the present invention;

Fig. 9 is a schematic view showing the flow processes in accordance with the third preferred embodiment of the present invention; and

Fig. 10 is an exploded view showing the parts in accordance with the fourth preferred embodiment of the present invention.

### DETAILED DESCRIPTION OF THE PREFERRED EMBODIMENT

The present invention will now be described more specifically with reference to the following embodiments. It is to be noted that the following descriptions of preferred embodiments of this invention are presented herein for the purpose of illustration and description only; it is not intended to be exhaustive or to be limited to the precise form disclosed.

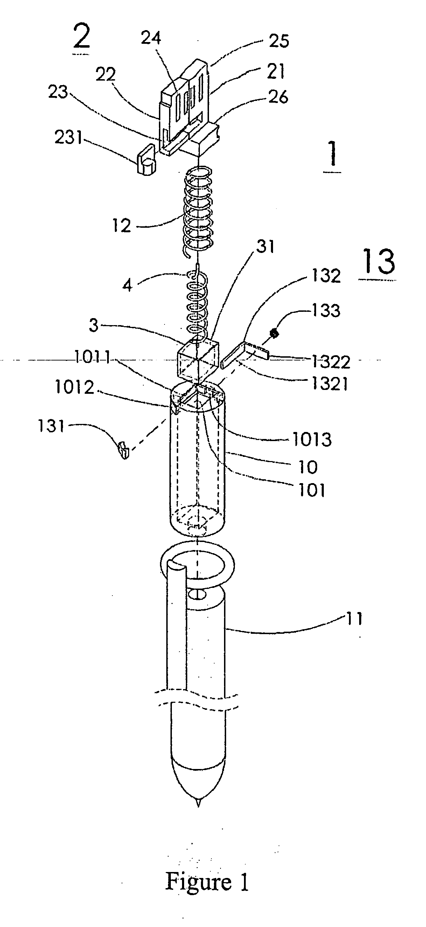

Please refer to Fig. 1, which shows a pen featuring as a USB memory device in accordance with the first embodiment of the present invention. The pen includes a penholder 1 having an upper penholder 10 and a lower penholder 11, in which the lower penholder 11 has a pen body, e.g. a refill case, and the upper penholder 10 and the lower penholder 11 can be detachably connected. The upper penholder 10 has an accommodation room 101 therein; one end of the accommodation room 101 communicates with an end of the upper penholder 10 and at least a compression spring 12 is disposed on the other end; at least a passageway 1011 is provided on one end of the accommodation room 101, one end of the passageway 1011 communicates with the outer periphery of the upper penholder 10 to form a notched hole 1012 and a cavity 1013 is disposed on the other end. Besides, the upper penholder 10 has at least a spring member 13 containing at least a press part 131, at least a push strip 132 and at least a compression spring 133, in which the push strip 132 has a first side end 1321 and a second side end 1322, the press part 131 is disposed on the outer periphery of the upper penholder 10 to correspond to the notched hole 1012, and the outer diameter of the upper penholder 10 is not greater than 12mm.

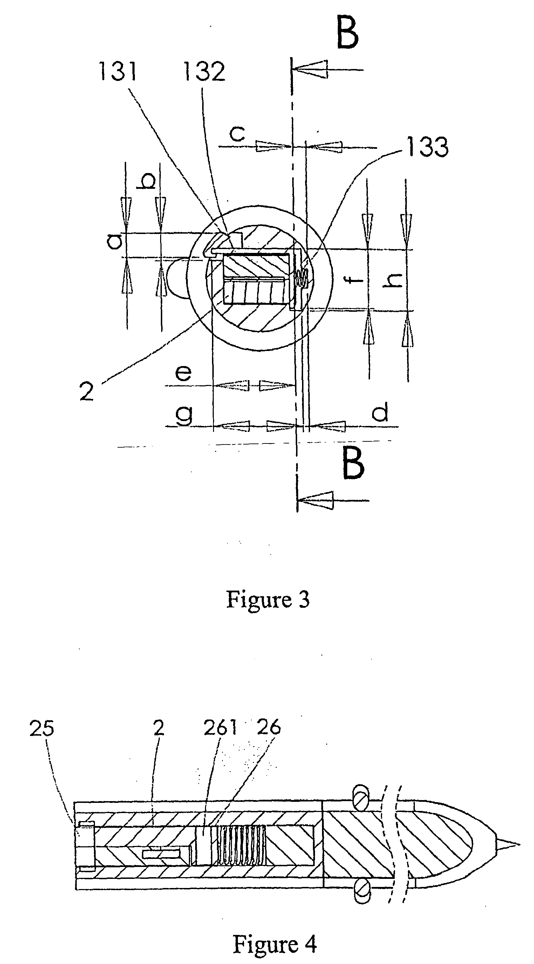

Please jointly refer to Fig. 1 and 3. The push strip 132 is housed in the passageway 1011 and the first side end 1321 of the push strip 132 is combined with the press part 131. The compression spring 133 is housed in the cavity 1013 of the passageway 1011 and is combined with the second side end 1322 of the push strip 132. When the foldable connection plug 2 is accommodated in the accommodation room 101 of the upper penholder 10, the height (c) of the compression spring 133 shall not be less than that (d) of the cavity 1013. The end-to-end length (a) of the outer periphery of the press part 131 shall not be greater than the end-to-end length (b) of the outer periphery of the notched hole 1012. Moreover, the end-to-end length (e+f) of the outer periphery of the push strip 132 shall not be greater than the end-to-end length (g+h) of the outer periphery of the passageway 1011.

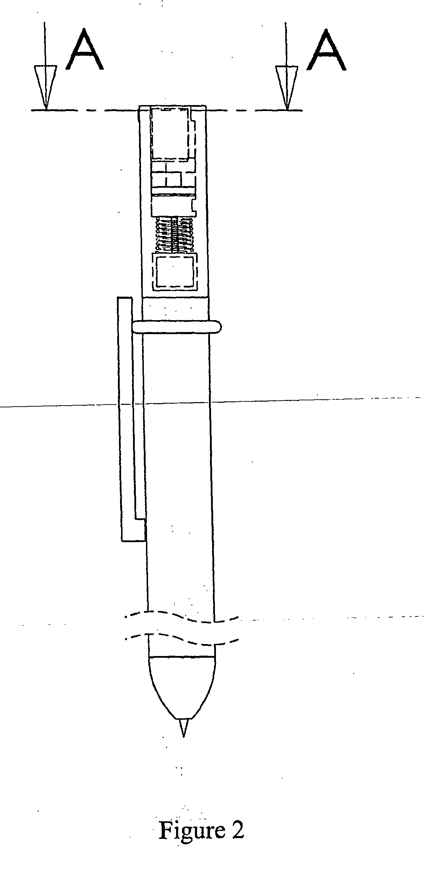

Please jointly refer to Fig. 2, 3, 4. The end face of the foldable connection plug 2 corresponding to the compression spring 133 has a first snap recess 25, and the end face of the support seat 26 opposite to the first snap recess 25 has a second snap recess 261.

Please jointly refer to Fig. 1, 3, 5. A foldable connection plug 2 is housed in an accommodation room 101 of the upper penholder 10. The foldable connection plug 2 includes the support seat 26, at least a first connection part 21, and at least a second connection part 22, in which the foldable connection plug 2 has metal contacts being compatible with a USB transmission interface, the metal contacts 24 are electrically connected with an electronic component being compatible with the USB transmission interface, and the electronic component which is compatible with the USB transmission interface can be an EDI (Electronic Data Interchange) device; and a main body 3 which is housed in the accommodation room 101 of the upper penholder 10 and contains at least an electronic component 31.

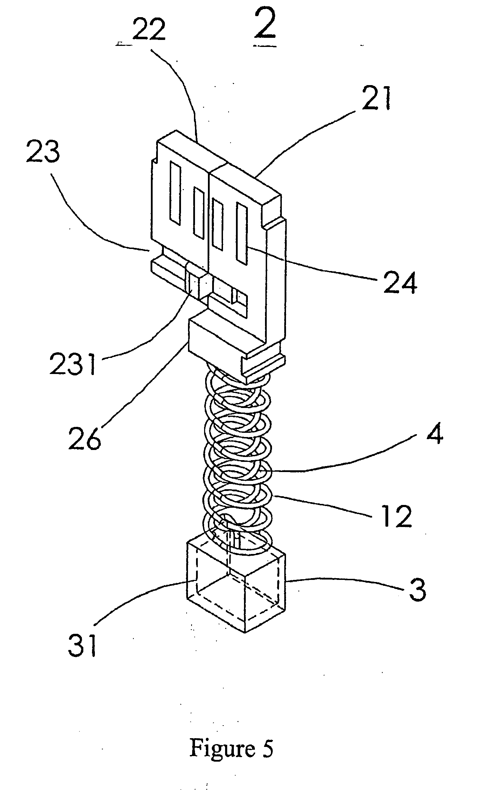

Please refer to Fig. 5. The foldable connection plug 2 has at least a track 23, in which the track 23 communicates with the opposite end faces of the first connection part 21 and the second connection part 22, and at least a fastener 231 is disposed on the track 23. The compression spring 12 is located between the support seat 26 and the main body 3. An electrical connection wire 4 is located between the support seat 26 and the main body 3, in which the main body 3 is electrically connected with the foldable connection plug 2 through the electrical connection wire 4.

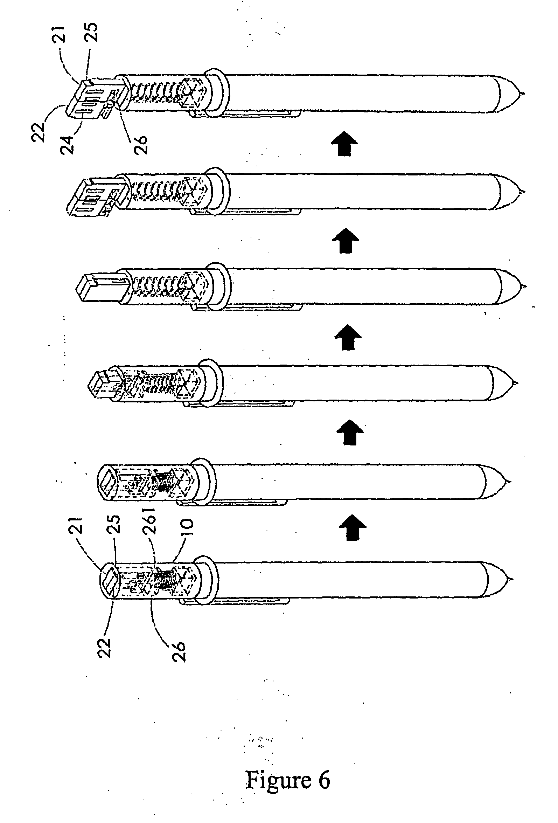

Please refer to Fig. 1, 6. When the foldable connection plug 2 is housed in the accommodation room 101, the second side end 1322 of the push strip 132 is engaged in the first snap recess 25 when the compression spring 12 in the accommodation room 101 is in a compressed state. When exerting force on the press part 131 of the spring member 13, the second side end 1322 of the push strip 132 is driven away from the first snap recess 25, and the compression spring 133 of the spring member 13 is in a compressed state. Meanwhile, the compression spring 12 in the accommodation room 101 release the pre-pressure so that the foldable connection plug 2 bounces out of the accommodation room 101. Releasing the press part 131 will get the second side end 1322 of the push strip 132 engaged in the second snap recess 261, and moving the fastener 231 to between the first connection part 21 and the second connection part 22 enables the first connection part 21 and the second connection part 22 not to be randomly crooked. The metal contacts 24 of the foldable connection plug 2 is electrically connected with an electronic component (not shown) being compatible with the USB transmission interface. The electronic component that is compatible with the USB transmission interface can be an EDI device, such as computer, digital camera, copy machine, mobile phone, and so forth.

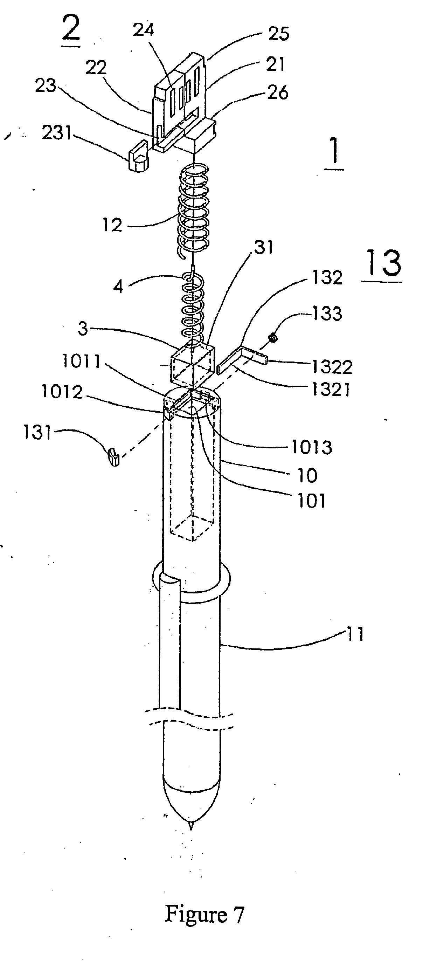

Please refer to Fig. 7, which shows the second preferred embodiment of the present invention and differs from the first preferred embodiment in that the upper penholder 10 and the lower penholder 11 are integrally formed. The rest of the embodiment is the same as that of the first preferred embodiment.

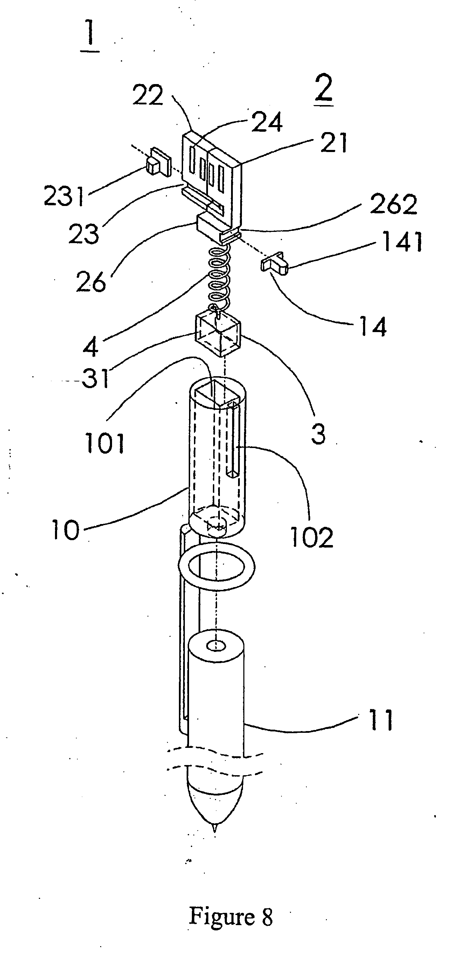

Please refer to Fig. 8, which shows the third preferred embodiment and is a pen featuring as a USB memory device. Similarly, the pen includes a penholder 1 having an upper penholder 10 and a lower penholder 11, in which the lower penholder 11 has a pen body, e.g. a refill case, and the upper penholder 10 and a lower penholder 11 can be detachably connected. The upper penholder 10 has an accommodation room 101 therein; one end of the accommodation room 101 communicates with an outer periphery of the upper penholder 10, and the outer diameter of the upper penholder is not greater than 12mm.

Please refer to Fig. 8. A foldable connection plug 2 is housed in the accommodation room 101 of the upper penholder 10. The foldable connection plug 2 includes a support seat 26, at least a first connection part 21, and at least a second connection part 22, in which the foldable connection plug 2 has metal contacts 24 being compatible with a USB transmission interface, the metal contacts 24 are electrically connected with an electronic component with a USB transmission interface, the electronic component that is compatible with the USB transmission interface can be an EDI device, the support seat 26 has a recess 262, a movable seat is disposed on the recess 262, and the movable seat 14 has a push part 141; a main body 3 is housed in the accommodation room 101 of the upper penholder 10 and contains at least an electronic component 31.

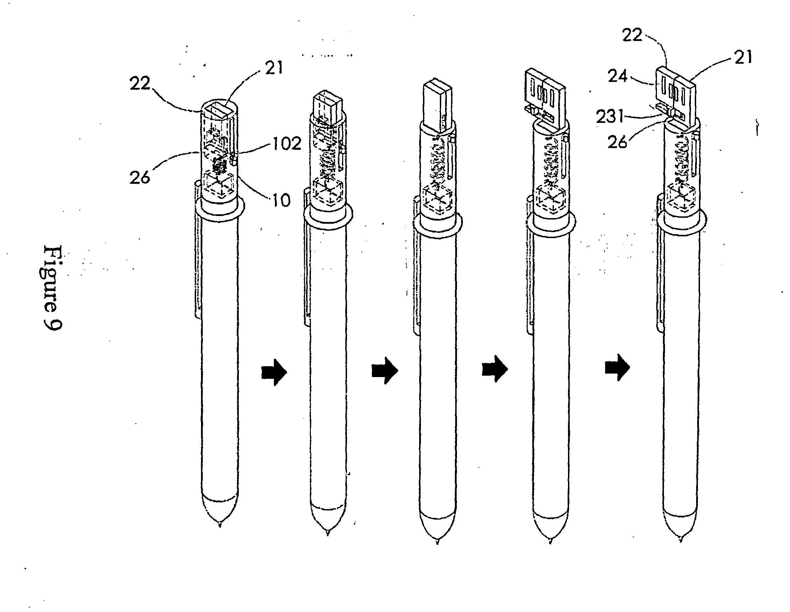

Please refer to Fig. 8, 9. A slot hole 102 is provided on the periphery of the upper penholder 10 to correspond to the recess 262 of the foldable connection plug 2. The slot hole 102 penetrates through the inner wall and outer wall of the upper penholder 10, the push part 141 goes through the slot hole 102, and the outer end of the push part 141 is protruding beyond the outer periphery of the upper penholder 10.

Please further refer to Fig. 8, 9. The foldable connection plug 2 has at least a track 23 communicating with the opposite end faces of the first connection part 21 and the second connection part 22, in which a fastener 231 is disposed on the track 23. An electrical connection wire 4 is located between the support seat 26 and the main body 3, in which the main body 3 is electrically connected with the foldable connection plug 2 via the electrical connection wire 4.

Please further refer to Fig. 8, 9. When the foldable connection plug 2 is housed in the accommodation room 101, exert force on the push part 141 to move the push part 141 along the slot hole 102 so as to push the foldable connection plug 2 out of the accommodation room 101; move the fastener 231 to between the first connection part 21 and the second connection part 22 so that the first connection part 21 and the second connection part 22 won't be randomly crooked; electrically connect the metal contacts 24 of the foldable connection plug 2 with the electronic component (not shown) being compatible with a USB transmission interface, in which the electronic component (not shown) can be an EDI device, such as computer, digital camera, copy machine, mobile phone, and so forth.

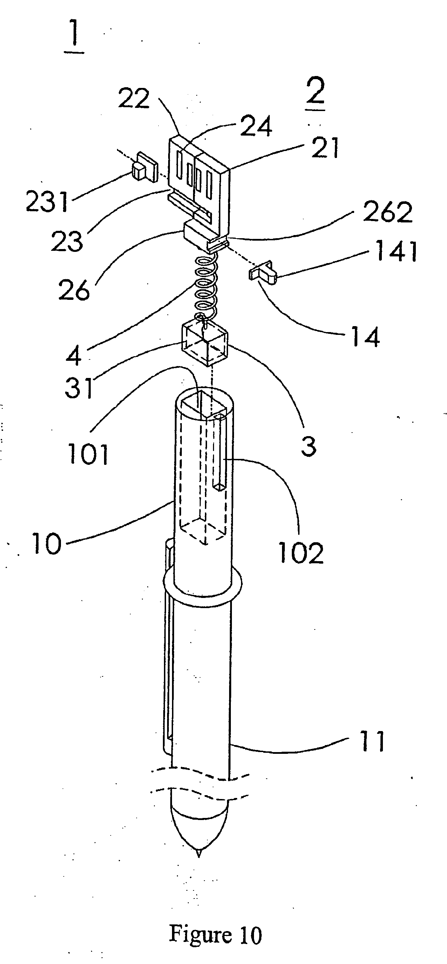

Please refer to Fig. 10, which shows the fourth preferred embodiment of the present invention and differs from the third preferred embodiment in that the upper penholder 10 and the lower penholder 11 are integrally formed. The rest of the embodiment is the same as that of the third preferred embodiment.

In sum, the present invention provides a pen featuring as a USB memory device, which allows the pen to maintain its original function in conveniently carrying and holding with ease, enable the memory itself to be advantageous to have a compact size by employing the miniaturization package technology, and house the foldable connection plug and the memory in the accommodation room by virtue of the folding feature of the foldable connection plug, so that the foldable memory can be easily received without being lost. As a consequence, the present invention has a combinational function.

While the invention has been described in terms of what is presently considered to be the most practical and preferred embodiments, it is to be understood that the invention needs not be limited to the disclosed embodiments. On the contrary, it is intended to cover various modifications and similar arrangements included within the scope of the appended claims, which are to be accorded with the broadest interpretation so as to encompass all such modifications and similar structures.

## Claims

1. A pen featuring as a USB memory device, comprising:
a penholder (1) having an upper penholder (10) and a lower penholder (11), wherein the upper penholder has an accommodation room (101) therein, one end of the accommodation room communicates with an outer periphery of the upper penholder, at least a compression spring (12) is disposed at the other end of the accommodation room, the upper penholder has at least a spring member (13), and the lower penholder is provided to house a pen body,
said penholder (1) being **characterized in that** an outer diameter of the upper penholder (10) is not greater than 12mm and **in that** it further comprises
a foldable connection plug (2) housed in the accommodation room (101) of the upper penholder and having a support seat (26), said plug (2) including at least a first connection part (21), at least a second connection part (22) and a plurality of metal contacts (24) being compatible with a USB transmission interface, wherein the foldable connection plug (2) has at least a track (23), and the track communicates with opposite end faces of the first connection part (21) and the second connection part (22) and wherein at least a fastener (231) is disposed on said track (23), wherein the fastener is moved, in use, between the first connection part (21) and the second connection part (22), so that said first and second connection parts are not crooked,
and a main body (3) housed in the accommodation room (101) of the upper penholder (10) and having at least an electronic component (31).

2. The pen as claimed in claim 1, wherein the spring member (13) comprises at least a press part (131), at least a push strip (132) and at least a compression spring (133), the push strip has a first side end (1321) and a second side end (1322), one end of the accommodation room communicates with an edge of the upper penholder, at least a passageway (1011) is provided on an outer periphery of the accommodation room (101), one end of the passageway communicates with an outer periphery of the upper penholder to form a notched hole (1012) and a cavity (1013) is disposed on the other end.

3. The pen as claimed in claim 2, wherein the press part (131) is disposed on an outer periphery of the upper penholder (10) to correspond to the notched hole (1012), the push strip (132) is housed in the passageway (1011) and the first side end of the push strip is combined with the press part, the compression spring (133) is housed in the cavity (1013) of the passageway and is combined with the second side end of the push strip.

4. The pen as claimed in claim 2 or 3, wherein an end-to-end length of an outer periphery of the press part (131) is not greater than an end-to-end length of an outer periphery of the notched hole (1012).

5. The pen as claimed in any one of claims 2 to 4, wherein an end-to-end length of the outer periphery of the push strip (132) is not greater than an end-to-end length of an outer periphery of the passageway (1011).

6. The pen as claimed in any one of claims 2 to 5, wherein the height of the compression spring (133) is not less than the height of the notched hole (1012).

7. The pen as claimed in any one of claims 2 to 6, wherein an end face of the foldable connection plug (2) corresponding to the compression spring (133) has a first snap recess (25).

8. The pen as claimed in claim 7, wherein an end face of the support seat (26) opposite to the first snap recess (25) has a second snap recess (261).

9. The pen as claimed in any one of claims 1 to 8, wherein the compression spring (12) is located between the support seat (26) and the main body (3).

10. A method for operating a pen featuring as a USB memory device, **characterized in that** it comprises the following steps of:
(1) when the foldable connection plug (2) is housed in the accommodation room (101), engaging the second side end in the first snap recess (25) so that the compression spring (12) in the accommodation room is in a compressed state;
(2) exerting force on the push part of the spring member (13) to push the second side end of the push strip (132) out of the first snap recess (25) while the compression spring (133) of the spring member (13) is in a compressed state;
(3) releasing the pre-pressure of the compression spring (12) in the accommodation room (101) to let the foldable connection plug (2) bounce out of the accommodation room;
(4) loosening up the press part (131) to engage the second side end of the push strip (132) in the second snap recess (261);
(5) moving the fastener (231) along a track to between the first connection part (21) and the second connection part (22) so that the first connection part and the second connection part are not crooked; and
(6) electrically connecting the metal contacts (24) of the foldable connection plug (2) with a computer or an electronic component being compatible with a USB transmission interface.

11. A pen featuring as a USB memory device, comprising:
a penholder (1) having an upper penholder (10) and a lower penholder (11), wherein the upper penholder has an accommodation room (101) therein, one end of the accommodation room communicates with an outer periphery of the upper penholder, and the lower penholder is provided to house a pen body, said penholder being **characterized in that** an outer diameter of the upper penholder (10) is not greater than 12mm and **in that** it further comprises
a foldable connection plug (2) housed in the accommodation room (101) of the upper penholder, having a support seat (26), said plug (2) including at least a first connection part (21), at least a second connection part (22) and a plurality of metal contacts (24) being compatible with a USB transmission interface, wherein the foldable connection plug (2) has at least a track (23), and the track communicates with opposite end faces of the first connection part (21) and the second connection part (22), wherein the support seat has a recess (262), a movable seat (14) is disposed on the recess, and the movable seat (14) has a push part (141), and the second connection part (22) and wherein at least a fastener (231) is disposed on said track (23), wherein the fastener is moved, in use, between the first connection part (21) and the second connection part (22) so that said first and second connection parts are not crooked,
a main body (3) housed in the accommodation room of the upper penholder and having at least an electronic component (31).

12. The pen as claimed in claim 11, wherein a slot hole (102) is provided on an outer periphery of the upper penholder (11) to correspond to the recess of the foldable connection plug (2), the slot hole (102) penetrates through the inner wall and outer wall of the upper penholder, the push part (141) goes through the slot hole, and an outer end of the push part is protruded beyond the outer periphery of the upper penholder (11).

13. The pen as claimed in any one of claims 1 to 9, 11, 12, wherein the upper penholder (10) and the lower penholder (11) are integrally formed.

14. The pen as claimed in any one of claims 1 to 9, 11, 12, wherein the upper penholder (10) and the lower penholder (11) are detachably connected.

15. The pen as claimed in any one of claims 1 to 9, 11 to 14, wherein the metal contacts (24) are electrically connected with the electronic component (31) being compatible with the USB transmission interface, and the electronic component is an EDI device.

16. The pen as claimed in any one of claims 1 to 9, 11 to 15, wherein at least a fastener (231) is disposed on the track (23).

17. The pen as claimed in any one of claims 1 to 9, 11 to 16, wherein the main body (3) is electrically connected with the foldable connection plug (2) via an electrical connection wire (4).

18. A method for operating a pen featuring as a USB memory device, **characterized in that** it comprises the following steps of:
(1) housing the foldable connection plug (2) in the accommodation room (101);
(2) exerting force on the push part to move the push part (141) along the slot hole (102) so as to push the foldable connection plug out of the accommodation room;
(3) moving the fastener (231) along a track to between the first connection (21) part and the second connection part (22) so that the first connection part and the second connection part are not crooked; and
(4) electrically connecting the metal contacts (24) of the foldable connection plug (2) with a computer or an electronic component being compatible with a USB transmission interface.

## Patentansprüche

1. Schreibstift, welcher als USB-Speichervorrichtung verwendet werden kann, umfassend:
einen Federhalter (1), welcher einen oberen Federhalter-Abschnitt (10) und einen unteren Federhalter-Abschnitt (11) aufweist, wobei der obere Federhalter-Abschnitt eine Aufnahmekammer (101) in demselben aufweist, ein Ende der Aufnahmekammer mit einem äußeren Rand des oberen Federhalter-Abschnitts in Verbindung steht, wenigstens eine Druckfeder (12) am anderen Ende der Aufnahmekammer angeordnet ist, der obere Federhalter-Abschnitt wenigstens ein Federelement (13) aufweist, und der untere Federhalter-Abschnitt derart bereitgestellt ist, daß darin ein Schreibelement untergebracht ist,
wobei der Federhalter (1) **dadurch gekennzeichnet ist, daß** ein Außendurchmesser des oberen Federhalter-Abschnitts (10) nicht größer als 12 mm ist und daß er ferner aufweist:
einen zusammenklappbaren Verbindungsstecker (2), welcher in der Aufnahmekammer (101) des oberen Federhalter-Abschnitts untergebracht ist und welcher ein Trägerelement (26) aufweist, wobei der Stecker (2) wenigstens einen ersten Verbindungsabschnitt (21), wenigstens einen zweiten Verbindungsabschnitt (22) und mehrere metallene Kontakte (24) umfaßt, welche mit einer USB-Schnittstelle kompatibel sind, wobei der zusammenklappbare Verbindungsstecker (2) wenigstens eine Führung (23) aufweist und die Führung mit gegenüberliegenden Endflächen des ersten Verbindungsabschnitts (21) und des zweiten Verbindungsabschnitts (22) in Verbindung steht und wobei wenigstens ein Befestigungselement (231) in der Führung (23) angeordnet ist, wobei das Befestigungselement beim Gebrauch zwischen dem ersten Verbindungsabschnitt (21) und dem zweiten Verbindungsabschnitt (22) derart bewegt wird, daß der erste und der zweite Verbindungsabschnitt keinen Knick bilden,
und einen Hauptkörper (3), welcher in der Aufnahmekammer (101) des oberen Federhalter-Abschnitts (10) untergebracht ist und welcher wenigstens ein elektronisches Bauteil (31) aufweist.

2. Schreibstift nach Anspruch 1, wobei das Federelement (13) wenigstens ein Drückelement (131), wenigstens einen Drückstreifen (132) und wenigstens eine Druckfeder (133) umfaßt, der Drückstreifen ein Ende (1321) an einer ersten Seite und eine Ende (1322) an einer zweiten Seite aufweist, ein Ende der Aufnahmekammer in Verbindung steht mit einer Kante des oberen Federhalter-Abschnitts, wenigstens ein Durchgang (1011) bereitgestellt ist an einem äußeren Rand der Aufnahmekammer (101), ein Ende des Durchgangs mit einem äußeren Rand des oberen Federhalter-Abschnitts derart in Verbindung steht, daß eingekerbtes Loch (1012) gebildet und eine Vertiefung (1013) an dem anderen Ende angeordnet ist.

3. Schreibstift nach Anspruch 2, wobei das Drückelement (131) an einem äußeren Rand des oberen Federhalter-Abschnitts (10) derart angeordnet ist, daß es dem eingekerbten Loch (1012) entspricht, der Drückstreifen (132) in dem Durchgang (1011) untergebracht ist, und das Ende an der ersten Seite des Drückstreifens mit dem Drückelement kombiniert ist, die Druckfeder (133) in der Vertiefung (1013) des Durchgangs untergebracht und mit dem Ende an der zweiten Seite des Drückstreifens kombiniert ist.

4. Schreibstift nach Anspruch 2 oder 3, wobei eine Gesamtlänge eines äußeren Umfangs des Drückelements (131) nicht größer ist als eine Gesamtlänge eines äußeren Umfangs des eingekerbten Lochs (1012).

5. Schreibstift nach einem der Ansprüche 2 bis 4, wobei eine Gesamtlänge des äußeren Umfangs des Drückstreifens (132) nicht größer ist als eine Gesamtlänge eines äußeren Umfangs des Durchgangs (1011).

6. Schreibstift nach einem der Ansprüche 2 bis 5, wobei die Höhe der Druckfeder (133) nicht kleiner ist als die Höhe des eingekerbten Lochs (1012).

7. Schreibstift nach einem der Ansprüche 2 bis 6, wobei eine Endfläche des zusammenklappbaren Verbindungssteckers (2), die mit der Druckfeder(133) korrespondiert, eine erste Einrast-Ausnehmung (25) aufweist.

8. Schreibstift nach Anspruch 7, wobei eine Endfläche des Trägerelements (26), welche der ersten Einrast-Ausnehmung (25) gegenüberliegt, eine zweite Einrast-Ausnehmung (261) aufweist.

9. Schreibstift nach einem der Ansprüche 1 bis 8, wobei die Druckfeder (12) sich zwischen dem Trägerelement (26) und dem Hauptkörper (3) befindet.

10. Verfahren zum Betätigen eines Schreibstifts, welcher als USB-Speichervorrichtung verwendet werden kann, **dadurch gekennzeichnet, daß** es die folgenden Schritte umfaßt:
(1) In-Eingriff-Bringen des Endes an der zweiten Seite mit der ersten Einrast-Vertiefung (25), wenn der zusammenklappbare Verbindungsstecker (2) in der Aufnahmekammer (101) untergebracht ist, derart, daß die Druckfeder (12) in der Aufnahmekammer sich in einem zusammengedrückten Zustand befindet,
(2) Ausüben einer Kraft auf das Drückelement des Federelements (13), um das Ende an der zweiten Seite des Drückstreifens (132) aus der ersten Einrast-Vertiefung (25) hinauszudrücken, während sich die Druckfeder (133) des Federelements (13) in einem zusammengedrückten Zustand befindet,
(3) Freigeben der Vorspannung der Druckfeder (12) in der Aufnahmekammer (101), um den zusammenklappbaren Verbindungsstecker (2) aus der Aufnahmekammer springen zu lassen,
(4) Lösen des Drückelements (131), um das Ende an der zweiten Seite des Drückstreifens (132) mit der zweiten Einrast-Vertiefung (261) in Eingriff zu bringen,
(5) Bewegen des Befestigungselements (231) entlang einer Führung zwischen dem ersten Verbindungsabschnitt (21) und dem zweiten Verbindungsabschnitt (22) derart, daß der erste Verbindungsabschnitt und der zweite Verbindungsabschnitt keinen Knick bilden, und
(6) elektrisches Verbinden der metallenen Kontakte (24) des faltbaren Verbindungssteckers (2) mit einem Computer oder einem elektronischen Bauteil, welcher/-es mit einer USB-Schnittstelle kompatibel ist.

11. Schreibstift, welcher als USB-Speichervorrichtung verwendet werden kann, umfassend:
einen Federhalter (1), welcher einen oberen Federhalter-Abschnitt (10) und einen unteren Federhalter-Abschnitt (11) aufweist, wobei der obere Federhalter-Abschnitt eine Aufnahmekammer (101) in demselben aufweist, ein Ende der Aufnahmekammer mit einem äußeren Rand des oberen Federhalter-Abschnitts in Verbindung steht, und der untere Federhalter-Abschnitt derart bereitgestellt ist, daß darin ein Schreibelement untergebracht ist, wobei der Federhalter **dadurch gekennzeichnet ist, daß** ein Außendurchmesser des oberen Federhalter-Abschnitts (10) nicht größer ist als 12 mm, und daß er ferner aufweist:
einen zusammenklappbaren Verbindungsstecker (2), welcher in der Aufnahmekammer (101) des oberen Federhalter-Abschnitts untergebracht ist und welcher ein Trägerelement (26) aufweist, wobei der Stecker (2) wenigstens einen ersten Verbindungsabschnitt (21), wenigstens einen zweiten Verbindungsabschnitt (22) und mehrere metallene Kontakte (24) umfaßt, welche mit einer USB-Schnittstelle kompatibel sind, wobei der zusammenklappbare Verbindungsstecker (2) wenigstens eine Führung (23) aufweist und die Führung mit gegenüberliegenden Endflächen des ersten Verbindungsabschnitts (21) und des zweiten Verbindungsabschnitts (22) in Verbindung steht, wobei das Trägerelement eine Ausnehmung (262) aufweist, ein bewegliches Element (14) in der Ausnehmung angeordnet ist, und das bewegliche Element (14) ein Schiebe-Element (141) aufweist, und wobei wenigstens ein Befestigungselement (231) in der Führung (23) angeordnet ist, wobei das Befestigungselement beim Gebrauch zwischen dem ersten Verbindungsabschnitt (21) und dem zweiten Verbindungsabschnitt (22) derart bewegt wird, daß der erste und der zweite Verbindungsabschnitt keinen Knick bilden, und
einen Hauptkörper (3), welcher in der Aufnahmekammer (101) des oberen Federhalter-Abschnitts (10) untergebracht ist und welcher wenigstens ein elektronisches Bauteil (31) aufweist.

12. Schreibstift nach Anspruch 11, wobei eine schlitzförmige Öffnung (102) an einem äußeren Rand des oberen Federhalter-Abschnitts (11) bereitgestellt ist, um zu der Ausnehmung des zusammenklappbaren Verbindungssteckers (2) zu korrespondieren, die schlitzförmige Öffnung (102) durch die innere Wand und die äußere Wand des oberen Federhalter-Abschnitts hindurchgeht, das Schiebe-Element (141) durch die schlitzförmige Öffnung hindurchgeht, und ein äußeres Ende des Schiebe-Elements über den äußeren Umfang des oberen Federhalter-Abschnitts (11) hinaus vorspringt.

13. Schreibstift nach einem der Ansprüche 1 bis 9, 11, 12, wobei der obere Federhalter-Abschnitt (10) und der untere Federhalter-Abschnitt (11) in einem Stück ausgebildet sind.

14. Schreibstift nach einem der Ansprüche 1 bis 9, 11, 12, wobei der obere Federhalter-Abschnitt (10) und der untere Federhalter-Abschnitt (11) lösbar verbunden sind.

15. Schreibstift nach einem der Ansprüche 1 bis 9, 11 bis 14, wobei die metallenen Kontakte (24) mit dem elektronischen Bauteil (31) elektrisch verbunden sind, wobei diese kompatibel sind mit der USB-Schnittstelle, und wobei das elektronische Bauteil eine EDI-Vorrichtung ist.

16. Schreibstift nach einem der Ansprüche 1 bis 9, 11 bis 15, wobei wenigstens ein Befestigungselement (231) in der Führung (23) angeordnet ist.

17. Schreibstift nach einem der Ansprüche 1 bis 9, 11 bis 16, wobei der Hauptkörper (3) mit dem zusammenklappbaren Verbindungsstecker (2) über eine elektrische Verbindungsleitung (4) elektrisch verbunden ist.

18. Verfahren zum Betätigen eines Schreibstifts, welcher als USB-Speichervorrichtung verwendet werden kann, **dadurch gekennzeichnet, daß** es die folgenden Schritte umfaßt:
(1) Unterbringen des zusammenklappbaren Verbindungssteckers (2) in der Aufnahmekammer (101),
(2) Ausüben einer Kraft auf das Schiebe-Element, um das Schiebe-Element (141) entlang der schlitzförmigen Öffnung (102) derart zu bewegen, daß der zusammenklappbare Verbindungsstecker aus der Aufnahmekammer hinausgedrückt wird,
(3) Bewegen des Befestigungselements (231) entlang einer Führung zwischen dem ersten Verbindungsabschnitt (21) und dem zweiten Verbindungsabschnitt (22) derart, daß der erste Verbindungsabschnitt und der zweite Verbindungsabschnitt keinen Knick bilden, und
(4) elektrisches Verbinden der metallenen Kontakte (24) des faltbaren Verbindungssteckers (2) mit einem Computer oder einem elektronischen Bauteil, welcher/-es mit einer USB-Schnittstelle kompatibel ist.

## Revendications

1. Crayon fonctionnant en tant que dispositif de mémoire USB, comportant :
un support de crayon (1) ayant un support de crayon supérieur (10) et un support de crayon inférieur (11), le support de crayon supérieur ayant un logement de réception (101), une extrémité du logement de réception communiquant avec une périphérie externe du support de crayon supérieur, au moins un ressort de compression (12) étant disposé à l'autre extrémité du logement de réception, le support de crayon supérieur ayant au moins un élément de ressort (13), et le support de crayon inférieur étant prévu pour loger un corps de crayon,
ledit support de crayon (1) étant **caractérisé en ce qu'**un diamètre extérieur du support de crayon supérieur (10) n'est pas plus grand que 12mm et **en ce qu'**il comporte en outre
une fiche de connexion repliable (2) logée dans le logement de réception (101) du support de crayon supérieur et ayant un siège de support (26), ladite fiche (2) comprenant au moins une première partie de connexion (21), au moins une deuxième partie de connexion (22) et une pluralité de contacts en métal (24) qui sont compatibles avec une interface de transmission USB, la fiche de connexion repliable (2) ayant au moins une piste (23), et la piste communiquant avec des faces d'extrémité opposées de la première partie de connexion (21) et de la deuxième partie de connexion (22) et dans lequel au moins un élément de fixation (231) est disposé sur ladite piste (23), l'élément de fixation étant déplacé, lors de l'utilisation, entre la première partie de connexion (21) et la deuxième partie de connexion (22) de telle sorte que lesdites première et deuxième parties de connexion ne sont pas décalées,
et un corps principal (3) logé dans le logement de réception (101) du support de crayon supérieur (10) et ayant au moins un composant électronique (31).

2. Crayon selon la revendication 1, dans lequel l'élément de ressort (13) comporte au moins une partie de pression (131), au moins une bande de poussée (132) et au moins un ressort de compression (133), la bande de poussée a une première extrémité latérale (1321) et une deuxième extrémité latérale (1322), une extrémité du logement de réception communique avec un bord du support de crayon supérieur, au moins un passage (1011) est prévu sur une périphérie externe du logement de réception (101), une extrémité du passage communique avec une périphérie externe du support de crayon supérieur afin de former un trou à encoche (1012) et une cavité (1013) est disposée sur l'autre extrémité.

3. Crayon selon la revendication 2, dans lequel la partie de pression (131) est disposée sur une périphérie externe du support de crayon supérieur (10) pour correspondre au trou à encoche (1012), la bande de poussée (132) est logée dans le passage (1011) et la première extrémité latérale de la bande de poussée est combinée avec la partie de pression, le ressort de compression (133) est logé dans la cavité (1013) du passage et est combiné avec la deuxième extrémité latérale de la bande de poussée.

4. Crayon selon la revendication 2 ou 3, dans lequel une longueur bout à bout d'une périphérie externe de la partie de pression (131) n'est pas plus grande qu'une longueur bout à bout d'une périphérie externe du trou à encoche (1012).

5. Crayon selon l'une quelconque des revendications 2 à 4, dans lequel une longueur bout à bout de la périphérie externe de la bande de poussée (132) n'est pas plus grande qu'une longueur bout à bout d'une périphérie externe du passage (1011).

6. Crayon selon l'une quelconque des revendications 2 à 5, dans lequel la hauteur du ressort de compression (133) n'est pas inférieure à la hauteur du trou à encoche (1012).

7. Crayon selon l'une quelconque des revendications 2 à 6, dans lequel une face d'extrémité de la fiche de connexion repliable (2) correspondant au ressort de compression (133) a un premier renfoncement d'encliquetage (25).

8. Crayon selon la revendication 7, dans lequel une face d'extrémité du siège de support (26) opposé au premier renfoncement d'encliquetage (25) a un deuxième renfoncement d'encliquetage (261).

9. Crayon selon l'une quelconque des revendications 1 à 8, dans lequel le ressort de compression (12) est disposé entre le siège de support (26) et le corps principal (3).

10. Procédé de mise en oeuvre d'un crayon fonctionnant en tant que dispositif de mémoire USB, **caractérisé en ce qu'**il comporte les étapes suivantes consistant à :
(1) quand la fiche de connexion repliable (2) est logée dans le logement de réception (101), engager la deuxième extrémité latérale dans le premier renfoncement d'encliquetage (25) de telle sorte que le ressort de compression (12) dans le logement de réception est dans un état comprimé ;
(2) exercer une force sur la partie de poussée de l'élément de ressort (13) afin de pousser la deuxième extrémité latérale de la bande de poussée (132) hors du premier renfoncement d'encliquetage (25) tandis que le ressort de compression (133) de l'élément de ressort (13) est dans un état comprimé ;
(3) libérer la pré-pression du ressort de compression (12) dans le logement de réception (101) afin de laisser la fiche de connexion repliable (2) rebondir hors du logement de réception ;
(4) relâcher la partie de pression (131) afin d'engager la deuxième extrémité latérale de la bande de poussée (132) dans le deuxième renfoncement d'encliquetage (261) ;
(5) déplacer l'élément de fixation (231) le long d'une piste entre la première partie de connexion (21) et la deuxième partie de connexion (22) de telle sorte que la première partie de connexion et la deuxième partie de connexion ne sont pas décalées ; et
(6) connecter électriquement les contacts en métal (24) de la fiche de connexion repliable (2) à un ordinateur ou à un composant électronique qui est compatible avec une interface de transmission USB.

11. Crayon fonctionnant en tant que dispositif de mémoire USB, comportant :
un support de crayon (1) ayant un support de crayon supérieur (10) et un support de crayon inférieur (11), le support de crayon supérieur ayant un logement de réception (101), une extrémité du logement de réception communiquant avec une périphérie externe du support de crayon supérieur, et le support de crayon inférieur est prévu pour loger un corps de crayon, ledit support de crayon étant **caractérisé en ce qu'**un diamètre extérieur du support de crayon supérieur (10) n'est pas plus grand que 12mm et **en ce qu'**il comporte en outre
une fiche de connexion repliable (2) logée dans le logement de réception (101) du support de crayon supérieur, ayant un siège de support (26), ladite fiche (2) comprenant au moins une première partie de connexion (21), au moins une deuxième partie de connexion (22) et une pluralité de contacts en métal (24) qui sont compatibles avec une interface de transmission USB, la fiche de connexion repliable (2) ayant au moins une piste (23), et la piste communiquant avec des faces d'extrémité opposées de la première partie de connexion (21) et de la deuxième partie de connexion (22), le siège de support ayant un renfoncement (262), un siège mobile (14) étant disposé sur le renfoncement, et le siège mobile (14) ayant une partie de poussée (141), et
au moins un élément de fixation (231) est disposé sur ladite piste (23), l'élément de fixation étant déplacé, lors de l'utilisation, entre la première partie de connexion (21) et la deuxième partie de connexion (22) de telle sorte que lesdites première et deuxième parties de connexion ne sont pas décalées,
un corps principal (3) logé dans le logement de réception du support de crayon supérieur et ayant au moins un composant électronique (31).

12. Crayon selon la revendication 11, dans lequel un trou de fente (102) est prévu sur une périphérie externe du support de crayon supérieur (11) afin de correspondre au renfoncement de la fiche de connexion repliable (2), le trou de fente (102) pénètre à travers la paroi intérieure et la paroi extérieure du support de crayon supérieur, la partie de poussée (141) passe à travers le trou de fente, et une extrémité extérieure de la partie de poussée est amenée à dépasser au delà de la périphérie extérieure du support de crayon supérieur (11).

13. Crayon selon l'une quelconque des revendications 1 à 9, 11, 12, dans lequel le support de crayon supérieur (10) et le support de crayon inférieur (11) sont formés d'un seul tenant.

14. Crayon selon l'une quelconque des revendications 1 à 9, 11, 12, dans lequel le support de crayon supérieur (10) et le support de crayon inférieur (11) sont reliés de manière démontable.

15. Crayon selon l'une quelconque des revendications 1 à 9, 11 à 14, dans lequel les contacts en métal (24) sont électriquement connectés au composant électronique (31) qui est compatible avec l'interface de transmission USB, et le composant électronique est un dispositif EDI.

16. Crayon selon l'une quelconque des revendications 1 à 9, 11 à 15, dans lequel au moins un élément de fixation (231) est disposé sur la piste (23).

17. Crayon selon l'une quelconque des revendications 1 à 9, 11 à 16, dans lequel le corps principal (3) est électriquement connecté à la fiche de connexion repliable (2) par l'intermédiaire d'un fil de connexion électrique (4).

18. Procédé de mise en oeuvre d'un crayon fonctionnant en tant que dispositif de mémoire USB, **caractérisé en ce qu'**il comporte les étapes suivantes consistant à :
(1) loger la fiche de connexion repliable (2) dans le logement de réception (101) ;
(2) exercer une force sur la partie de poussée afin de déplacer la partie de poussée (141) le long du trou de fente (102) de façon à pousser la fiche de connexion repliable hors du logement de réception ;
(3) déplacer l'élément de fixation (231) le long d'une piste entre la première partie de connexion (21) et la deuxième partie de connexion (22) de telle sorte que la première partie de connexion et la deuxième partie de connexion ne sont pas décalées ; et
(4) connecter électriquement les contacts en métal (24) de la fiche de connexion repliable (2) à un ordinateur ou à un composant électronique qui est compatible avec une interface de transmission USB.
